# EUROPÄISCHE PATENTSCHRIFT

(11) **EP 1 014 776 B1**
(45) Veröffentlichungstag und Bekanntmachung des Hinweises auf die Patenterteilung: **10.09.2003**
(21) Anmeldenummer: 98124651.5
(22) Anmeldetag: 24.12.1998
(51) Int. Cl.: H05K 13/04, H05K 3/30

(54) **Verfahren zum mechanischen Befestigen von elektrischen Bauteilen auf einer Platine sowie eine Vorrichtung hergestellt nach diesem Verfahren**
Method for mechanicaly fixing components on a board and device for applying this method
Méthode pour fixer mécaniquement des composants électriques sur une platine et dispositif pour mettre en oeuvre cette méthode

(43) Veröffentlichungstag der Anmeldung: 28.06.2000
(73) Patentinhaber: Nokia Corporation, 02150 Espoo (FI)
(72) Erfinder: Richter, Lutz, 10369 Berlin (DE)
(74) Vertreter: TER MEER STEINMEISTER & PARTNER GbR

(56) Entgegenhaltungen:
- DE-A- 4 226 168
- DE-A- 19 729 073
- US-A- 4 644 445

## Beschreibung

Die Erfindung betrifft ein Verfahren zum mechanischen Befestigen von elektrischen Bauteilen auf einer Platine sowie eine nach diesem Verfahren hergestellte Platine.

### Stand der Technik

Gemäß dem Stand der Technik ist es bekannt, auf Platinen aufgesetzte elektrische Bauteile nicht nur mittels leitfähiger Verbindungen, sondern zusätzlich auch noch mittels einer mechanischer Befestigung miteinander zu verbinden.

Im einzelnen wird dies so realisiert, daß zunächst das elektrische Bauteil mit seinen zur Kontaktierung vorgesehenen Kontakten auf die auf der Platine vorgesehen Kontaktflächen aufgesetzt wird und zwischen den jeweiligen Kontakten und Kontaktbereichen leitfähige Verbindungen hergestellt werden. Sind die so verbundenen elektrischen Bauteile kaum thermisch beansprucht und sind die leitfähigen Verbindungen korrosionsbeständig, sind in aller Regel keine zusätzlichen und über die hergestellten leitfähigen Verbindungen hinausgehenden mechanischen Befestigungen dieser Bauteile auf der Platine erforderlich. Eine Ausnahme bilden in diesem Zusammenhang lediglich solche Bauteile, die wegen ihres Gewichts und der auf die Bauteile bzw. Platine wirkenden Erschütterungen nach einer zusätzlichen mechanischen Befestigung verlangen. Je nach den gegebenen Verhältnissen kann diese zusätzliche mechanische Befestigung der elektrischen Bauteile auf der Platine durch die Verwendung von Klebstoffen oder auch Halteklammern realisiert sein.

Auf die Verwendung von entsprechenden Halteklammern wird jedoch aus Kostengründen bei solchen elektrischen Bauteilen völlig verzichtet, die wegen ihrer geringen Baugröße nur ein sehr geringes Gewicht haben. Vielmehr werden solche Bauteile ausschließlich durch Klebstoff mechanisch auf der Platine befestigt, wenn befürchtet werden muß, daß beispielsweise wirkende Erschütterungen zu einem Aufheben der elektrischen Verbindungen bzw. einem Abfallen des elektrischen Bauteils von der Platine führen können.

Je kleiner die elektrischen Bauteile werden, desto geringer werden jedoch die Probleme, die mit der erschütterungsfesten Befestigung der elektrischen Bauteile im Zusammenhang stehen. Dies ist im wesentlichen darauf zurückzuführen, daß in Anbetracht des mit der geringen Größe des jeweiligen elektrischen Bauteiles verbundenen geringen Gewichts die vorhandenen elektrischen Verbindungen jederzeit eine ausreichende Befestigung des jeweiligen Bauteils auf der Platine sicherstellen können.

Auch wenn entsprechend der Ausführungen im letzten Absatz der Eindruck erweckt wird, daß bei kleinen elektrischen Bauteilen keine über die elektrische Verbindung hinausgehende Befestigung dieser Bauteile an der Platine notwendig ist, hat sich jedoch gezeigt, daß eher das Gegenteil der Fall ist und Klebstoff zur zusätzlichen mechanischen Befestigung der elektrischen Bauteile eingesetzt wird. Die Verwendung von Klebstoff zur zusätzlichen Befestigung vor allem von kleinen elektrischen Bauteilen auf der Platine hat seinen Grund darin, daß die jeweiligen elektrischen Verbindungen oftmals Scherkräften ausgesetzt werden, die ihre Ursache darin haben, daß die mit der Platine versehenen elektrischen Bauteile sich im Betrieb häufig erwärmen und/oder aber in einer temperaturbelasteten Umgebung betrieben werden, obwohl die Wärmeausdehungskoeffizienten der Platine und der jeweiligen elektrischen Bauteile unterschiedlich groß sind. Außerdem wird der Klebstoff zur Herbeiführung der Korrosionsbeständigkeit der elektrischen Verbindungen eingesetzt, indem der Klebstoff nicht nur eine zusätzliche mechanische Befestigung zwischen Platine und jeweiligem elektrischen Bauteil herstellt, sondern gleichzeitig auch die elektrischen Verbindungen wie eine Schutzschicht überzieht bzw. in sich einbettet.

Um die im letzten Absatz näher erläuterten Wirkungen des Klebstoffs herbeizuführen, wird zunächst dafür gesorgt, daß das jeweilige elektrische Bauteil nach dem Herstellen der jeweiligen elektrischen Verbindungen mit geringem Abstand zur jeweiligen Platine angeordnet ist. Werden diese Bedingungen eingehalten, entsteht zwischen der Platine und dem jeweiligen elektrischen Bauteil ein Raum, dessen -seitliche- Ränder im wesentlichen vom Umfangsrand des jeweiligen elektrischen Bauteils gebildet werden. Sodann werden mittels einer Nadel oder Düse die Ränder des gebildeten Raumes abgefahren, wobei ständig ein dünnflüssiger Klebstoff aus der Nadel oder Düse austritt. Bedingt durch die Kapillarwirkung des Raumes läuft der Klebstoff in den Raum und befestigt nach seinem Aushärten das elektrische Bauteil zusätzlich auf der Platine. Befinden sich die elektrischen Verbindungen zwischen dem elektrischen Bauteil und der Platine, werden diese, nachdem der Klebstoff in den gebildeten Raum eingedrungen ist, von diesem gleichzeitig auch gegen Korrosion geschützt. Sind die elektrischen Verbindungen seitlich am jeweiligen elektrischen Bauteil ausgeführt, ist es notwendig, die Nadel oder Düse mit größerem seitlichen Abstand zu den Rändern an diesen vorbeizuführen, damit der aufgebrachte Klebstoff auch die seitlich angebrachten elektrischen Verbindungen überziehen kann.

Abgesehen davon, daß die Verwendung von dünnflüssigen Klebstoffen einen nicht unerheblichen Kostenfaktor darstellt, führt die Dünnflüssigkeit der Klebstoffe auch zu Handlingproblemen. Diese sind darauf zurückzuführen, daß der eine wasserähnliche Viskosität habende Klebstoff nach seinem Auftrag sehr leicht in nicht gewünschte Richtungen fließen kann. Die Folge ist, daß die Bereiche, in welche der Klebstoff unerwünschtermaßen geflossen ist, zu einer Versiegelung von Räumen oder Raumbereichen führt, die entsprechend dem Weg der Nadel oder Düse erst später mit Klebstoff gefüllt werden sollen. Da aber die vorzeitige Versiegelung nicht sicherstellen kann, daß durch sie der jeweilige Raum oder Raumbereiche in gleicher Weise mit Klebstoff gefüllt wird, wie dies ohne Versiegelung durch den zeitlich späteren Klebstoffauftrag der Fall wäre, und i.ü. ein Eindringen des späteren Klebstoffauftrags in den jeweiligen Raum oder Raumbereich verhindert, können sehr leicht Hohlräume unterhalb der elektrischen Bauteile entstehen, welche Festigkeit der herzustellenden Klebstoffverbindung reduzieren. Will man die vorzeitige Versiegelung von Räumen oder Raumteilen ausschließen, ist der ohnehin für die Bewegung der Nadel oder Düse erforderliche Zwischenraum zwischen den verschiedenen auf einer Platine angeordneten Bauteilen zu vergrößern, womit gleichzeitig auch die Größe der Geräte ansteigt, die solche Platinen aufnehmen.

Neben diesen Problemen wird auch als nachteilig empfunden, daß das zur Unterfütterung der elektrischen Bauteile notwendige optischen Erkennen und spätere Abfahren der Ränder mit der Nadel oder Düse sehr zeitaufwendig ist. Deshalb werden in der Praxis zur Gewährleistung entsprechend großer Stückzahlen eine Mehrzahl von teueren, die optische Erkennung und Verklebung von Bauteilen ausführende Maschinen entweder parallel oder seriell betrieben.

Aus der US 4,644,445, die eine Befestigungsstruktur für einen integrierten Schaltkreis auf einer Leiterplatte betrifft, ist es bereits bekannt, den Raum unter dem elektrischen Bauteil oder integrierten Schaltkreis mit einem Epoxyharz zu füllen, dass durch ein Loch in einer Platine zugeführt wird. Dabei quillt das Epoxyharz aus dem Raum zwischen Bauteil und der Platine hervor, wobei die unter dem Bauteil angeordneten Bauteilkontakte, die in elektrisch leitender Verbindung mit Leiterbahnen auf der Platine stehen, von dem heraus quellenden Epoxyharz eingehüllt werden.

Der vorliegenden Erfindung liegt die Aufgabe zugrunde, ein Verfahren und eine Platine der eingangs genannten Art bereitzustellen, mit dem bzw. bei der eine zuverlässige Verklebung des Bauteils mit der Platine bei gleichzeitigem Schutz der Lötstellen vor Korrosion erreichbar ist.

Diese Aufgabe wird durch das Verfahren nach Anspruch 1 und die Platine nach Anspruch 4 gelöst.

Entsprechend dem erfindungsgemäßen Verfahren wird der Klebstoff solange in den Raum zwischen Platine und Bauteil eingefüllt, bis er aus dem Raum herausquillt und dabei gleichzeitig die seitlich aus dem Bauteil herausgeführten Kontakte umhüllt.

Somit lässt sich eine erfindungsgemäße Platine herstellen, bei der die seitlich aus dem Bauteil herausgeführten Kontakte vollständig von Klebstoff umhüllt sind, sodass sie gegen Korrosion geschützt sind.

### Darstellung der Erfindung

Diese Aufgabe wird verfahrensmäßig durch die Merkmale von Anspruch 1 und vorrichtungsmäßig durch die Merkmale gemäß Anspruch 4 gelöst. Vorteilhafte Aus- und Weiterbildungen sind den Ansprüchen 2,3 und 5,6 zu entnehmen.

Dadurch, daß gemäß dem erfindungsgemäßen Verfahren der Klebstoff nicht durch Nutzung der Kapillarwirkung in den Raum gelangt, sondern direkt in den Raum injiziert und darin verteilt wird, können die seitlichen Abstände der verschiedenen auf der Platine angeordneten elektrischen Bauteile reduziert werden, da die für den Nadel- bzw. Düsenweg notwendigen Räume nicht zur Verfügung gestellt werden müssen. Außerdem ist beim erfinderischen Verfahren eine niedrige Viskosität des Klebstoffs nicht erforderlich, um die Unterfütterung des elektrischen Bauteils mit Klebstoff herbeizuführen. Aber selbst dann, wenn beim erfinderischen Verfahren Klebstoff mit niedriger Viskosität eingesetzt wird, muß beim hier angegebenen Verfahren nicht befürchtet werden, daß der am Rand austretende Klebstoff in Räume oder Raumbereiche von benachbarten Bauteilen eindringt und dort über die oben dargestellte Versiegelung zur Hohlraumbildung beiträgt, denn selbst dann, wenn durch das Befüllen eines Raums eine vollständige oder auch nur teilweise Versiegelung des Raumes unterhalb eines benachtbarten Bauteils eintritt, kann, da der benachbarte Raum ebenfalls von *innen nach außen* gefüllt, die teilweise Versiegelung des Randes ein vollständiges Befüllen nicht verhindern.

Der der Raum solange mit Klebstoff gefüllt, bis dieser an wenigstens am Rand herausquillt, lassen sich elektrische Verbindungen eines elektrischen Bauteils, die seitlich am elektrischen Bauteil herausgeführt sind, sehr einfach in den Klebstoff einbetten und durch den Klebstoff vor Korrosion schützen.

Vorteilhafterweise weist bei der Befüllung des Raums gemäß Anspruch 3 der Klebstoff eine honigartige Viskosität auf, um ein Herausspritzen des Klebstoffs an den Rändern zu vermeiden.

Besonders einfach ist die Verfahrensführung dann, wenn die Platine und/oder das elektrische Bauteil innerhalb der vom Rand gezogenen Grenzen wenigstens eine Füllöffnung aufweist, durch welche der Klebstoff in den Raum gefüllt werden kann. Nicht nur, daß die so angeordneten Füllöffnungen eine Verteilung des Klebstoff von *innen nach außen* gewährleisten, wird durch sie die sonst beim Abfahren der Ränder der elektrischen Bauteile erforderliche Bauteilserkennung und Bauteilsvermessung überflüssig. Dies gilt insbesondere dann, wenn die jeweiligen Füllöffnungen in der Platine ausgebildet sind, denn durch die vorbestimmte Position der Füllöffnungen auf der Platine wird selbst dann noch eine saubere Verklebung von elektrischen Bauteilen sichergestellt, wenn diese nach ihrem Aufbringen auf die Platine eine leicht von der Sollage abweichende Lage haben.

### Kurze Darstellung der Figur

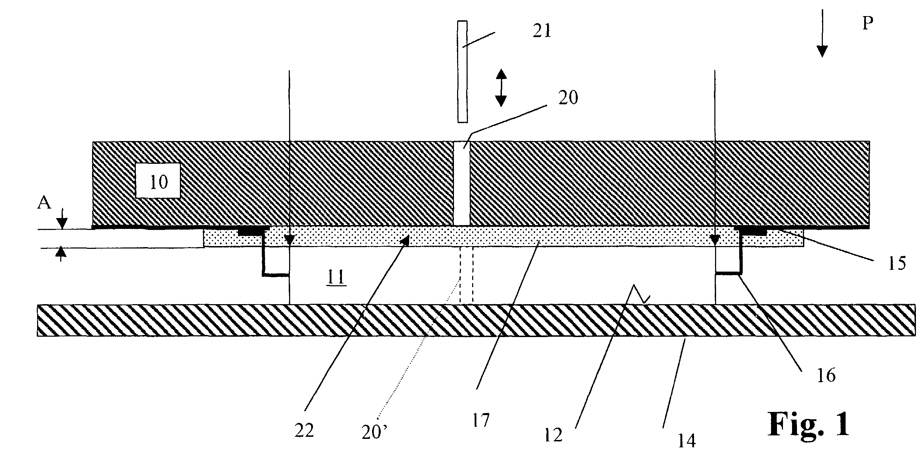

Es zeigt
- Fig. 1: einen Schnitt durch ein auf eine Platine aufgesetztes Bauteil.

### Wege zum Ausführen der Erfindung

Die Erfindung soll nun anhand der Fig. näher erläutert werden.

In Fig. 1 ist ein Schnitt durch eine Platine 10 gezeigt, die mit einem elektrischen Bauteil 11 yersehen ist. Diese Einheit von Platine 10 und elektrischem Bauteil 11 wurde dergestalt gebildet, daß zunächst das elektrische Bauteil 11, welches vorliegend ein Schaltkreis ist, mit seiner Oberfläche 12 auf dem Montagetisch 14 ausgerichtet wurde. Sodann wurde in einem zweiten Schritt in Pfeilrichtung P die Platine 10 auf das Bauteil 11 abgesenkt. Es kann jedoch auch das jeweilige Bauteil 11 auf die auf einem Montagetisch 14 ruhende Platine 10 aufgesetzt werden.

Die Kontaktierung des elektrischen Bauteils 11 mit den Kontaktbereichen 15 auf der Platine 10 erfolgt in der Weise, daß nach dem Aufsetzen des Bauteils 11 auf die Platine 11 die Kontakte 16, welche seitlich aus dem Bauteil 11 herausgeführt sind, mit den auf der Platine 10 befindlichen Kontaktbereichen 15 in bekannter Weise verlötet werden.

Deutlich ist der Darstellung gemäß Fig. 1 entnehmbar, daß, nachdem die elektrisch leitenden Verbindungen zwischen den Kontakten 16 und den Kontaktbereichen 15 hergestellt sind, ein gegenseitiger Abstand A zwischen den einander zugewandten Oberflächen von Platine 10 und Bauteil 11 verbleibt. Um zu verhindern, daß es unter Temperatureinwirkung und der damit verbundenen unterschiedlichen Wärmedehnung zu einem Abreißen der hergestellten elektrischen Verbindungen kommen kann, wird im Abstand A eine Lage aus Klebstoff 17 angeordnet. Gemäß der Erfindung wird diese Lage aus Klebstoff 17 dergestalt erzeugt, daß zunächst innerhalb der Grenzen eines Randes 19, der vorliegend von der Kontur des jeweils zu befestigenden Bauteils 11 bestimmt wird, ein Loch 20 in der Platine 10 erzeugt wird, durch welches dann mittels einer Düse 21 Klebstoff 17 in den vom Rand 19 begrenzten und dem Abstand A gebildeten Raum 22 gefüllt wird. Es sei darauf hingewiesen, daß das Loch 20 auch vor der Verbindung von Bauteil 11 und Platine 10 hergestellt werden kann und daß bei großen Bauteilen 11 in der Platine 10 auch mehrere Löcher 20 zum Einfüllen des Klebstoffs 17 vorgesehen sein können.

Wie Fig. 1 weiter entnehmbar ist, ist die dort ausgebildete Lage aus Klebstoff 17 nicht nur auf den Raum 22 beschränkt, sondern schließt auch die leitenden Verbindungen zwischen den seitlich aus dem Bauteil 11 herausgeführten Kontakte 16 und den auf der Platine 10 angebrachten Kontaktbereiche 15 ein. Hierdurch wird sichergestellt, daß durch den Überzug mit Klebstoff 17 die leitenden Verbindungen zwischen den Kontakten 16 und den Kontaktbereichen 15 vor Korrosion geschützt sind. Verfahrenstechnisch wird die Ausdehnung der Lage aus Klebstoff 17 bis über die Ränder 19 dadurch erreicht, daß der Klebstoff 17 unter entsprechendem Druck in den Raum 22 eingefüllt wird, so daß er unter dem Rand 19 hindurch bis in die Bereiche der leitenden Verbindungen zwischen den Kontakten 16 und den Kontaktbereichen 15 hervorquellen kann.

Mit der Füllöffnung 20' in dem Bauteil 11 ist angedeutet, daß die Füllung des Raums 22 nicht notwendig durch die Platine 10 erfolgen muß.

Es sei noch angemerkt, daß die auf der Plating 10 angeordneten Kontaktbereiche 15 als Leiterbahnen ausgebildet sind.

## Patentansprüche

1. Verfahren zum mechanischen Befestigen von elektrischen Bauteilen auf einer Platine, deren wenigstens eine Kontakt (16) seitlich aus dem Bauteil (11) herausgeführt ist bei dem
- in einem ersten Schritt wenigstens ein am elektrischen Bauteil (11) vorhandener Kontakt (16), mit einem auf der Platine befindlichen Kontaktbereich (15) zu einer leitfähigen Verbindung verbunden wird, wobei von dem Bauteil (11) und der Platine (10) ein dazwischen liegender Raum (22) festgelegt wird, und
- in einem zweiten Schritt ein Klebstoff (17) innerhalb eines von der Kontur des Bauteils (11) bestimmten Randes (19) in den Raum (22) eingefüllt wird.
**dadurch gekennzeichnet, dass**
- der Klebstoff (17) solange in den Raum (22) eingefüllt wird, dass er bei gleichzeitiger Umhüllung der jeweils hergestellten leitfähigen Verbindungen aus dem Raum (22) herausquillt.

2. Verfahren nach Anspruch 1, **dadurch gekennzeichnet, dass** der Klebstoff (17) durch eine Füllöffnung (20, 20'), die innerhalb der Grenzen des Randes (19) vorgesehen ist, mit Druck in den Raum (22) gepreßt wird.

3. Verfahren nach Anspruch 1 oder 2, **dadurch gekennzeichnet, dass** der Klebstoff (17) eine honigartige Viskosität aufweist.

4. Platine mit wenigstens einem Kontaktbereich (15) und einem elektrischen Bauteil (11), das wenigstens einen Kontakt (16) aufweist, der mit dem Kontaktbereich (15) zu einer leitfähigen Verbindung verbunden ist, wobei das Bauteil (11) einen zwischen ihm und der Platine liegenden Raum (22) festlegt, dessen Rand (19) von der Kontur des Bauteils bestimmt ist. wobei zum mechanischen Befestigen des Bauteils (11) auf der Platine (10) ein Klebstoff (17) verwendet ist,
**dadurch gekennzeichnet, dass**
- der wenigstens eine Kontakt (16) seitlich aus dem Bauteil (11) herausgeführt ist, und
- der aus dem Raum (22) herausgequollene Klebstoff die jeweils hergestellten leitfähigen Verbindungen umhüllt.

5. Platine nach Anspruch 3, **dadurch gekennzeichnet, dass** die Platine (10) innerhalb der von der Kontur des Bauteils (11) vorgegebenen Grenze wenigstens eine Füllöffnung (20) aufweist, durch die der Klebstoff (17) in den Raum (22) einfüllbar ist.

6. Platine nach Anspruch 4 oder 5, **dadurch gekennzeichnet, dass** das Bauteil (11) innerhalb seiner Kontur wenigstens eine Füllöffnung (20) aufweist, durch die der Klebstoff (17) in den Raum (22) einfüllbar ist.

## Claims

1. Method for mechanically fixing electrical components on a printed circuit board, the at least one contact (16) of which is led out laterally from the component (11), in which method
- in a first step, at least one contact (16) present on the electrical component (11) is connected to a contact region (15) located on the printed circuit board to form a conductive connection, the component (11) and the printed circuit board (10) defining a space (22) lying in between, and
- in a second step, an adhesive (17) is filled into the space (22) within a border (19) determined by the contour of the component (11),
**characterized in that**
- the adhesive (17) is filled into the space (22) until it wells out of the space (22) while simultaneously enveloping the conductive connections respectively established.

2. Method according to Claim 1, **characterized in that** the adhesive (17) is forced by pressure into the space (22) through a filling opening (20, 20'), which is provided within the limits of the border (19).

3. Method according to Claim 1 or 2, **characterized in that** the adhesive (17) has a honey-like viscosity.

4. Printed circuit board with at least one contact region (15) and an electrical component (11), which has at least one contact (16), which is connected to the contact region (15) to form a conductive connection, the component (11) defining a space (22) lying between it and the printed circuit board, the border (19) of which space is determined by the contour of the component, an adhesive being used for the mechanical fixing of the component (11) on the printed circuit board (10),
**characterized in that**
- the at least one contact (16) is led out laterally from the component (11), and
- the adhesive which has welled out of the space (22) envelops the conductive connections respectively established.

5. Printed circuit board according to Claim 3, **characterized in that** the printed circuit board (10) has within the limits predetermined by the contour of the component (11) at least one filling opening (20), through which the adhesive (17) can be filled into the space (22).

6. Printed circuit board according to Claim 4 or 5, **characterized in that** the component (11) has within its contour at least one filling opening (20), through which the adhesive (17) can be filled into the space (22).

## Revendications

1. Procédé de fixation mécanique de composants électriques sur une platine, dont au moins un contact (16) est guidé latéralement hore du composant (11), procédé dans lequel
- lors d'une première étape, au moins un contact (16), existant sur le composant électrique (11), est relié à une zone de contact (15) se trouvant sur la platine, pour établir une liaison conductrice, un espace (22) intermédiaire étant défini par le composant (11) et la platine (10), et
- lors d'une deuxième étape, un adhésif (17) est introduit dans l'espace (22) à l'interieur d'une bordure (19) déterminée par le contour de composant (11).
**caractérisé en ce que**
- l'adhésif (17) est introduit dans l'espace (22) jusqu'à ce qu'il fuie hors de l'espace (22) tout en enveloppant simultanément les liaisons conductrices chaque fois établies.

2. Procédé selon la revendication 1, **caractérisé en ce que** l'adhésif (17) est pressé, par l'effet d'une pression régnant dans l'espace (22), à travers une ouverture de remplissage (20, 20') prévue à l'intérieur des limites de la bordure (19).

3. Procédé selon la revendication 1 ou 2, **caractérisé en ce que** l'adhésif (17) présente une viscosité du genre de celle du miel.

4. Platine comportant au moins une zone de contact (15) et un composant électrique (11), présentant au moins un contact (16), relié à la zone de contact (15) pour établir une liaison conductrice, le composant (11) définissant, entre lui et la platine, un espace (22) dont la bordure (19) est déterminée par le contour du composant, sachant qu'un adhésif (17) est placé sur la platine (10), pour obtenir la fixation mécanique du composant (11),
**caractérisé en ce que**
- le au moins un contact (16) est guidé latéralement hors du composant (11), et
- l'adhésif ayant fui de l'espace (22) enveloppe les liaisons conductrices chaque fois établies.

5. Platine selon la revendication 3, **caractérisé en ce que** la platine (10) présente, à l'intérieur de la limite, prédéterminée par le contour du composant (11), au moins une ouverture de remplissage (20) à travers laquelle l'adhésif (17) peut être introduit dans l'espace (22).

6. Platine selon la revendication 4 ou 5, **caractérisé en ce que** le composant (11) présente, à l'intérieur de son contour, au moins une ouverture de remplissage (20), à travers laquelle l'adhésif (17) peut être introduit pour remplir l'espace (22) .
